# EUROPEAN PATENT APPLICATION

(11) **EP 3 885 475 A1**
(43) Date of publication of application: **29.09.2021**
(21) Application number: 21167454.4
(22) Date of filing: 06.07.2017
(51) Int. Cl.: C25D 7/12, C25D 3/16, H01L 21/288, H01L 23/532, C25D 3/18, H01L 21/768

(54) **COMPOSITION FOR COBALT PLATING COMPRISING ADDITIVE FOR VOID-FREE SUBMICRON FEATURE FILLING**

(30) Priority: 18.07.2016 EP 16179956
(62) Divisional of application: 17735150.9
(71) Applicant: BASF SE, 67056 Ludwigshafen am Rhein (DE)
(72) Inventor: Kienle, Marcel, Patrik, 67117 Limburgerhof (DE); Mayer, Dieter, 67056 Ludwigshafen (DE); Arnold, Marco, 67056 Ludwigshafen (DE); Fluegel, Alexander, 67056 Ludwigshafen (DE); Emnet, Charlotte, 67056 Ludwigshafen (DE)
(74) Representative: BASF IP Association

(57) **Abstract**

Use of a compound of formula I 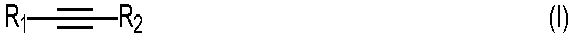 for depositing cobalt on semiconductor substrates comprising recessed features having an aperture size below 100 nm, preferably below 50 nm
wherein
R¹ is selected from X-Y;
R² is selected from R¹ and R³;
X is selected from linear or branched C₁ to C₁₀ alkanediyl, linear or branched C₂ to C₁₀ alkenediyl, linear or branched C₂ to C₁₀ alkynediyl, and -(C₂H₃R⁶-O)ₘ-;
Y is selected from OR³;
R³is selected from (i) H, (ii) C₅ to C₂₀ aryl, (iii) C₁ to C₁₀ alkyl (iv) C₆ to C₂₀ arylalkyl, (v) C₆ to C₂₀ alkyl aryl, which may be substituted by OH, SO₃H, COOH or a combination thereof, and (vi) (C₂H₃R⁶⁻O)ₙ-H, ;
m, n are integers independently selected from 1 to 30;
R⁶ is selected from H and C₁ to C₅ alkyl.

## Description

The present invention relates to a composition for cobalt plating comprising cobalt ions comprising an agent for void-free filling of recessed features on semiconductor substrates.

### Background of the Invention

Filling of small features, such as vias and trenches, by metal electroplating is an essential part of the semiconductor manufacture process. It is well known, that the presence of organic substances as additives in the electroplating bath can be crucial in achieving a uniform metal deposit on a substrate surface and in avoiding defects, such as voids and seams, within the metal lines.

For copper electroplating the void-free filling of submicrometer-sized interconnect features by using additives to ensure bottom-up filling is well known in the art.

For conventional nickel electroplating on substrates like metals, metal alloys, and metallized polymers, particularly copper, iron, brass, steel, cast iron or chemically deposited copper or nickel on polymer surfaces brightening additives comprising acetylenic compounds are known.

EP 0025694 A discloses a nickel electroplating bath comprising nickel and zinc ions, saccharin and an sulfonated acetylenic compound to receive a bright, well leveled nickel deposit. As sulfonated acetylenic compound 2-butyne-1,4-disulfonic acid, 2-butyne sulfonic acid, propyne sulfonic acid, 1-butyne sulfonic acid, 1-pentyne sulfonic acid are explicitly mentioned. US 2008/0308429 A discloses an acidic aqueous electrolyte solution for production of a nickel cathode comprising nickel ions, and 2, 5-dimethyl-3-hexyne-2, 5-diol. WO 97/35049 discloses the use of hydroxy or amino substituted alkynes in combination with allyl or vinyl ammonium compounds in nickel electroplating. US 4,435,254 discloses acetylenic amines or sulfonated acetylenic compounds.

With further decreasing aperture size of recessed features like vias or trenches the filling of the interconnects with copper becomes especially challenging, also since the copper seed deposition by physical vapor deposition (PVD) prior to the copper electrodeposition might exhibit inhomogeneity and non-conformity and thus further decreases the aperture sizes particularly at the top of the apertures. Furthermore, it becomes more and more interesting to substitute copper by cobalt since cobalt shows less electromigration into the dielectric.

For cobalt electroplating several additives were proposed to ensure void-free filling of submicrometer-sized features. US 2011/0163449 A1 discloses a cobalt electrodeposition process using a bath comprising a cobalt deposition-inhibiting additive, such as saccharin, coumarin or polyethyleneimine (PEI). US 2009/0188805 A1 discloses a cobalt electrodeposition process using a bath comprising at least one accelerating, inhibiting, or depolarizing additive selected from polyethyleneimine and 2-mercapto-5-benzimidazolesulfonic acid.

There is still a need for a cobalt electroplating composition that allows a void-free deposition of cobalt in small recessed features, such as vias or trenches, of semiconductor substrates.

It is therefore an object of the present invention to provide an electroplating bath that is capable of providing a substantially void-free filling, preferably void-free and seam-free filling of features on the nanometer and/or on the micrometer scale with cobalt or a cobalt alloy.

### Summary of the Invention

The present invention provides a new class of highly effective additives that provide substantially void free filling of nanometer-sized interconnect features with cobalt or cobalt alloys.

Therefore, the present invention provides a composition comprising
(a) cobalt ions, and
(b) an additive of formula I 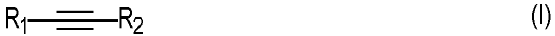 wherein
   - R¹: is selected from X-Y;
   - R²: is selected from R¹ and R³;
   - X: is selected from linear or branched C₁ to C₁₀ alkanediyl, linear or branched C₂ to C₁₀ alkenediyl, linear or branched C₂ to C₁₀ alkynediyl, and (C₂H₃R⁶-O)ₘ-H;
   - Y: is selected from OR³, NR³R⁴, N⁺R³R⁴R⁵ and NH-(C=O)-R³;
   - R³, R⁴, R⁵: are the same or different and are selected from (i) H, (ii) C₅ to C₂₀ aryl, (iii) C₁ to C₁₀ alkyl (iv) C₆ to C₂₀ arylalkyl, (v) C₆ to C₂₀ alkylaryl, which may be substituted by OH, SO₃H, COOH or a combination thereof, and (vi) (C₂H₃R⁶-O)ₙ-H and wherein R³ and R⁴ may together form a ring system, which may be interrupted by O or NR⁷;
   - m, n: are integers independently selected from 1 to 30;
   - R⁶: is selected from H and C₁ to C₅ alkyl.

   - R⁷: is selected from R⁶ and

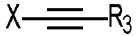

The invention further relates to the use of a metal plating bath comprising a composition as defined herein for depositing cobalt or cobalt alloys on substrates comprising recessed features having an aperture size of 100 nanometers or less, in particular 20 nm or less, 15 nm or less or even 7 nm or less.

The invention further relates to a process for depositing a layer comprising cobalt on a substrate comprising nanometer-sized features by
a) contacting a composition as defined herein with the substrate, and
b) applying a current density to the substrate for a time sufficient to deposit a metal layer onto the substrate.

In this way additives are provided that result in a void-free filling of recessed features.

### Brief description of the Figures

- Fig. 1: shows a FIB/SEM inspected wafer that was electroplated with cobalt according to comparative example 2;
- Fig. 2: shows a FIB/SEM inspected wafer that was electroplated with cobalt using an electroplating composition comprising an amino alkyne according to example 3;
- Fig. 3: shows a FIB/SEM inspected wafer that was electroplated with cobalt using an electroplating composition comprising an alkynol according to example 4;
- Fig. 4: shows a FIB/SEM inspected wafer that was electroplated with cobalt using an electroplating composition comprising an ethoxylated alkynol according to example 5.

### Detailed Description of the Invention

The compositions according to the inventions comprise cobalt ions, and an additive of formula I as described below.

### Additives according to the invention

It has been found that the additives of formula I 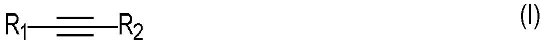 are particularly useful for electroplating cobalt or cobalt alloys into submicrometer-sized recessed features, particularly those having aperture sizes having nanometer or micrometer scale, in particular aperture sizes having 100 nanometers or less, 20 nm or less, 15 nm or less or even 7 nm or less.

According to the invention, R¹ is selected from X-Y, wherein X is a divalent spacer group selected from linear or branched C₁ to C₁₀ alkanediyl, linear or branched C₂ to C₁₀ alkenediyl, linear or branched C₂ to C₁₀ alkynediyl, and (C₂H₃R⁶-O)ₘ. m is an integer selected from 1 to 30, preferably from 1 to 15, even more preferably from 1 to 10, most preferably from 1 to 5.

In a preferred embodiment X is selected from linear or branched C₁ to C₆ alkanediyl, preferably from C₁ to C₄ alkanediyl.

In a preferred embodiment X is selected from methanediyl, ethane-1,1-diyl and ethane-1,2-diyl. In a second preferred embodiment X is selected from propane-1,1-diyl, butane-1,1-diyl, pentane-1,1-diyl, and hexane-1,1-diyl. In a third preferred embodiment X is elected from propane-2-2-diyl, butane-2,2-diyl, pentane-2,2-diyl, and hexane-2,2-diyl.
In a fourth preferred embodiment X is elected from propane-1-2-diyl, butane-1,2-diyl, pentane-1,2-diyl, and hexane-1,2-diyl. In a fifth preferred embodiment X is elected from propane-1-3-diyl, butane-1,3-diyl, pentane-1,3-diyl, and hexane-1,3-diyl.

Y is a monovalent group and may be selected from OR³, with R³ being selected from (i) H, (ii) C₅ to C₂₀ aryl, preferably C₅, C₆, and C₁₀ aryl, (iii) C₁ to C₁₀ alkyl, preferably C₁ to C₆ alkyl, most preferably C₁ to C₄ alkyl (iv) C₆ to C₂₀ arylalkyl, preferably C₆ to C₁₀ arylalkyl, (v) C₆ to C₂₀ alkylaryl, all of which may be substituted by OH, SO₃H, COOH or a combination thereof, and (vi) (C₂H₃R⁶-O)ₙ-H. In a preferred embodiment, R³ may be C₁ to C₆ alkyl or H. R⁶ may be selected from H and C₁ to C₅ alkyl, preferably from H and C₁ to C₄ alkyl, most preferably H, methyl or ethyl.

As used herein, aryl comprises carbocyclic aromatic groups as well as heterocyclic aromatic groups in which one or more carbon atoms are exchanged by one or more N or O atoms. As used herein, arylalkyl means an alkyl group substituted with one or more aryl groups, such as but not limited to benzyl and methylpyridine. As used herein, alkylaryl means an aryl group substituted with one or more alkyl groups, such as but not limited to toluyl.

In another preferred embodiment, R³ is selected from H to form a hydroxy group. In another preferred embodiment, R³ is selected from polyoxyalkylene groups of formula (C₂H₃R⁶-O)ₙ-H. R⁶ is selected from H and C₁ to C₅ alkyl, preferably from H and C₁ to C₄ alkyl, most preferably from H, methyl or ethyl. Generally, n may be an integer from 1 to 30, preferably from 1 to 15, most preferably from 1 to 10. In a particular embodiment polyoxymethylene, polyoxypropylene or a polyoxymethylene-co-oxypropylene may be used. In another preferred embodiment, R³ may be selected from C₁ to C₁₀ alkyl, preferably from C₁ to C₆ alkyl, most preferably methyl and ethyl.

Furthermore, Y may be an amine group NR³R⁴, wherein R³ and R⁴ are the same or different and may have the meanings of R³ described for OR³ above.

In a preferred embodiment, R³ and R⁴ are selected from H to form an NH₂ group. In another preferred embodiment, at least one of R³ and R⁴, preferably both are selected from polyoxyalkylene groups of formula (C₂H₃R⁶-O)ₙ-H. R⁶ is selected from H and C₁ to C₅ alkyl, preferably from H and C₁ to C₄ alkyl, most preferably H, methyl or ethyl. In yet another preferred embodiment, at least one of R³ and R⁴, preferably both are selected from C₁ to C₁₀ alkyl, preferably from C₁ to C₆ alkyl, most preferably methyl and ethyl.

R³ and R⁴ may also together form a ring system, which may be interrupted by O or NR⁷. R⁷ may be selected from R⁶ and 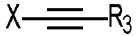 . Preferably the ring system is formed by two substituents R³ and R⁴ which are bound to the same N atom. Such ring system may preferably comprise 4 or 5 carbon atoms to form a 5 or 6 membered carbocyclic system. In such carbocyclic system one or two of the carbon atoms may be substituted by oxygen atoms.

Furthermore, Y may be a positively charged ammonium group N⁺R³R⁴R⁵. R³, R⁴, R⁵ are the same or different and may have the meanings of R³ described for OR³ and NR³R⁴ above. In a preferred embodiment R³, R⁴ and R⁵ are independently selected from H, methyl or ethyl. In one embodiment at least one of R³, R⁴ and R⁵, preferably two, most preferably all, are selected from polyoxyalkylene groups of formula (C₂H₃R⁶-O)ₙ-H.

m may be an integer selected from 1 to 30, preferably from 1 to 15, even more preferably from 1 to 10, most preferably from 1 to 5.

In the additives of formula I R² may be either R¹ or R³ as described above. If R² is R¹, R¹ may be selected to form a symmetric compound (both R¹s are the same) or an asymmetric compound (the two R¹s are different).

In a preferred embodiment R² is H.

Particularly preferred aminoalkynes are those in which
(a) R¹ is X-NR³R⁴ and R² is H;
(b) R¹ is X-NR³R⁴ and R² is X- NR³R⁴ with X being selected from linear C₁ to C₄ alkanediyl and branched C₃ to C₆ alkanediyl;

Particularly preferred hydroxyalkynes or alkoxyalkynes are those in which
(a) R¹ is X-OR³ and R² is H;
(b) R¹ is X-OR³ and R² is X- OR³ with X being selected from linear C₁ to C₄ alkanediyl and branched C₃ to C₆ alkanediyl;

Particularly preferred alkynes comprising an amino and a hydroxy group are those in which R¹ is X-OR³, particularly X-OH, and R² is X- NR³R⁴ with X being independently selected from linear C₁ to C₄ alkanediyl and branched C₃ to C₆ alkanediyl;

The amine groups in the additives may be selected from primary (R³, R⁴ is H), secondary (R³ or R⁴ is H) and tertiary amine groups (R³ and R⁴ are both not H).

The alkynes may comprise one or more terminal triple bonds or one or more non-terminal triple bonds (alkyne functionalities). Preferably, the alkynes comprise one or more terminal triple bonds, particularly from 1 to 3 triple bonds, most preferably one terminal triple bond.

Particularly preferred specific primary aminoalkynes are:

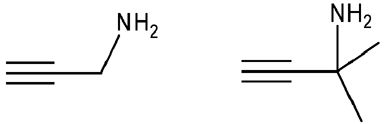

Particularly preferred specific secondary aminoalkynes are:

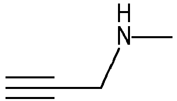

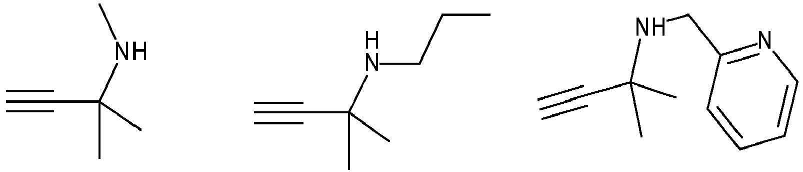

Particularly preferred specific tertiary aminoalkynes are:

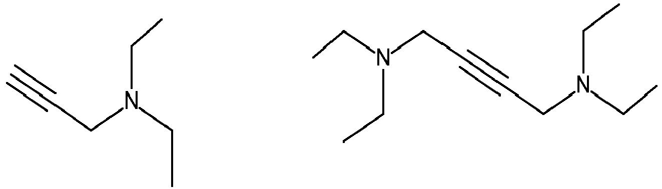

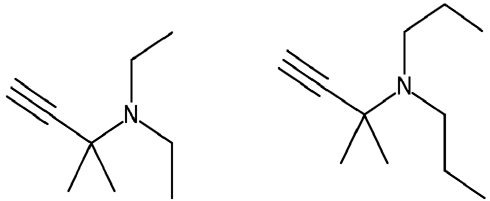

Other preferred additives are those in which the rests R³ and R⁴ may together form a ring system, which is optionally interrupted by O or NR³. Preferably, the rests R³ and R⁴ together form a C₅ or C₆ bivalent group in which one or two, preferably one, carbon atoms may be exchanged by O or NR^{7,} with R⁷ being selected from hydrogen, methyl or ethyl.

An example of such compounds is:

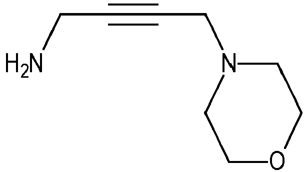

It may be received by reaction of propargyl amine with formaldehyde and morpholine,.

Another preferred additive comprising a saturated heterocyclic system is:

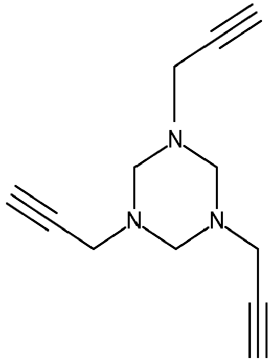

In this case R³ and R⁴ together form a ring system which is interrupted by two NR³ groups, in which R³ is selected from CH₂-C≡C-H. This additive comprises three terminal triple bonds.

The amino groups in the additives may further be quaternized by reaction with alkylating agents such as but not limited to dialkyl sulphates like DMS, DES or DPS, benzyl chloride or chlormethylpyridine. Particularly preferred quaternized additives are:

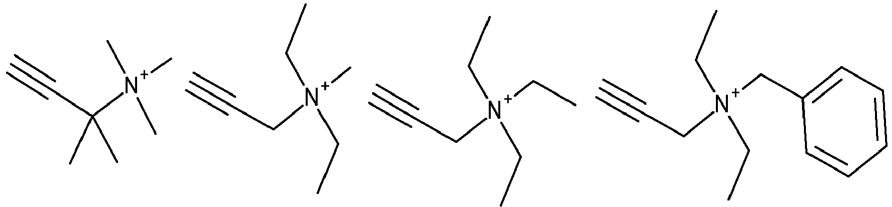

Particularly preferred specific pure hydroxyalkynes are:

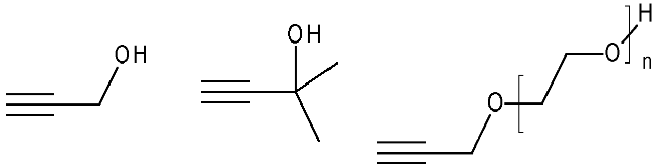

Particularly preferred specific aminoalkynes comprising OH groups are:

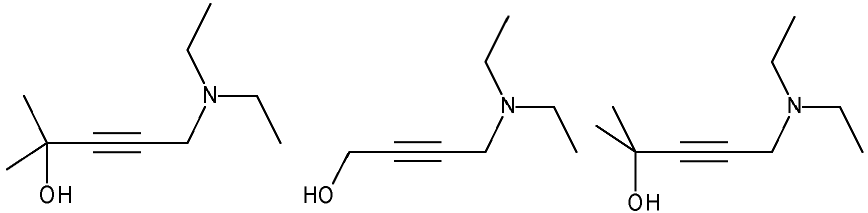

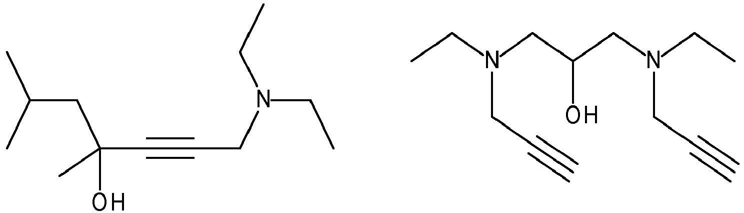

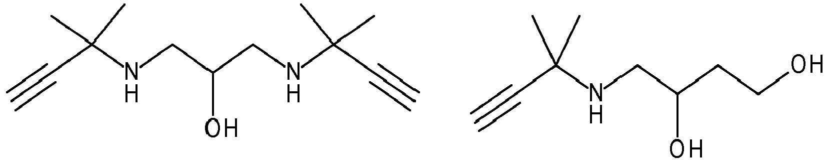

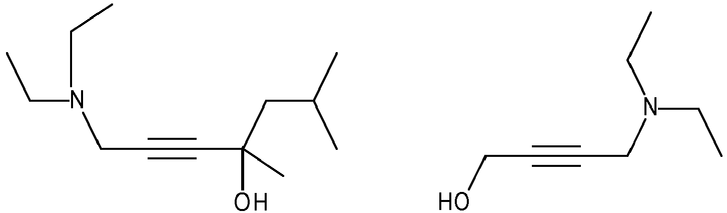

Also in this case the rests R³ and R⁴ may together form a ring system, which is optionally interrupted by O or NR³. Preferably, the rests R³ and R⁴ together form a C₅ or C₆ bivalent group in which one or two, preferably one, carbon atoms may be exchanged by O or NR^{7,} with R⁷ being selected from hydrogen, methyl or ethyl.

Examples for such compounds are:

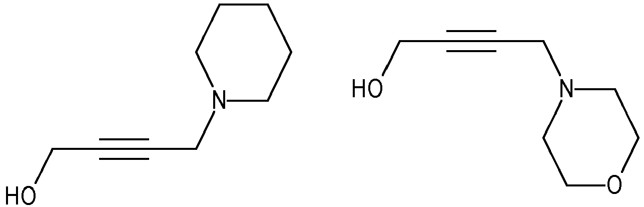

These may be received by reaction of propargyl alcohol with formaldehyde and piperidine or morpholine, respectively.

By partial reaction with alkylating agents mixtures of additives may be formed. In one embodiment, such mixtures may be received by reaction of 1 mole diethylaminopropyne and 0.5 mole epichlorohydrin, 1 mole diethylaminopropyne and 0.5 mole benzylchloride, 1 mole diethylaminopropyne with 0.9 mole dimethyl sulphate, 1 mole dimethyl propyne amine and 0.33 mole dimethyl sulphate, or 1 mole dimethyl propyne amine and 0.66 mole dimethyl sulphate. In another embodiment such mixtures may be received by reaction of 1 mole dimethyl propyne amine and 1.5, 1.9, or 2.85 mole dimethyl sulphate, 1 mole dimethyl propyne amine and 0.5 mole epichlorohydrin, 1 mole dimethyl propyne amine and 2.85 diethyl sulphate, or 1 mole dimethyl propyne amine and 1.9 mole dipropyl sulphate.

In a further embodiment, the additives may be substituted by SO₃H (sulfonate) groups or COOH (carboxy) groups. Specific sulfonated additives may be but are not limited to butynoxy ethane sulfonic acid, propynoxy ethane sulfonic acid, 1,4-di-(β-sulfoethoxy)-2-butyne, 3-(β-sulfoethoxy)-propyne.

In one embodiment a single additive according to the invention may be used in the cobalt electroplating baths. In another embodiment two or more of the additives are used in combination.

In general, the total amount of the additives according to the present invention in the electroplating bath is from 0.5 ppm to 10000 ppm based on the total weight of the plating bath. The additives according to the present invention are typically used in a total amount of from about 0.1 ppm to about 1000 ppm based on the total weight of the plating bath and more typically from 1 to 100 ppm, although greater or lesser amounts may be used.

### Other Additives

A large variety of further additives may typically be used in the bath to provide desired surface finishes for the Co plated metal. Usually more than one additive is used with each additive forming a desired function. Advantageously, the electroplating baths may contain one or more of wetting agents or surfactants like Lutensol®, Plurafac® or Pluronic® (available from BASF) to get rid of trapped air or hydrogen bubbles and the like. Further components to be added are grain refiners, stress reducers, levelers and mixtures thereof.

The bath may also contain a complexing agent for the cobalt ions, such as but not limited to sodium acetate, sodium citrate, EDTA, sodium tartrate, or ethylene diamine.

Further additives are disclosed in Journal of The Electrochemical Society, 156 (8) D301-D309 2009 "Superconformal Electrodeposition of Co and Co-Fe Alloys Using 2-Mercapto-5-benzimidazolesulfonic Acid", which is incorporated herein by reference.

In a further embodiment, surfactants may be present in the electroplating composition in order to improve wetting. Wetting agents may be selected from nonionic surfactants, anionic surfactants and cationic surfactants.

In a preferred embodiment non-ionic surfactants are used. Typical non-ionic surfactants are fluorinated surfactants, polyglocols, or poly oxyethylene and/or oxypropylene containing molecules.

### Electrolyte

In one embodiment, the usually aqueous plating bath used for void-free filling with cobalt or cobalt alloys may contain a cobalt ion source, such as but not limited to cobalt sulfate, cobalt chloride, or cobalt sulfamate.

For alloys the plating bath may further contain a source of a further metal ion source like nickel sulfate or chloride.

The cobalt ion concentration within the electroplating solution may be in a range of 0.01 to 1 mol/l. In one particular example, the ion concentration can have a range of 0.1 to 0.6 mol/l. In another particular example, the range can be from 0.3 to 0.5 mol/l. In yet another particular example, the range can be from 0.03 to 0.1 mol/l.

In a preferred embodiment the composition is essentially free from chloride ions. Essentially free from chloride means that the chloride content is below 1 ppm, particularly below 0.1 ppm.

During deposition, the pH of the plating bath may be adjusted to have a high Faradaic efficiency while avoiding the co-deposition of cobalt hydroxides. For this purpose, a pH range of 1 to 5 may be employed. In a particular example pH range of 2 to 4.5, preferably 2 to 4 can be employed. In another particular example, a pH range of 3 .5 to 4 can be used.

In a preferred embodiment boric acid may be used in the cobalt electroplating bath as supporting electrolyte.

### Process

An electrolytic bath is prepared comprising cobalt ions and at least one additive according to the invention. A dielectric substrate having the seed layer is placed into the electrolytic bath where the electrolytic bath contacts the at least one outer surface and the three dimensional pattern having a seed layer in the case of a dielectric substrate. A counter electrode is placed into the electrolytic bath and an electrical current is passed through the electrolytic bath between the seed layer on the substrate and the counter electrode. At least a portion of cobalt is deposited into at least a portion of the three dimensional pattern wherein the deposited cobalt is substantially void-free.

The present invention is useful for depositing a layer comprising cobalt on a variety of substrates, particularly those having nanometer and variously sized apertures. For example, the present invention is particularly suitable for depositing cobalt on integrated circuit substrates, such as semiconductor devices, with small diameter vias, trenches or other apertures. In one embodiment, semiconductor devices are plated according to the present invention. Such semiconductor devices include, but are not limited to, wafers used in the manufacture of integrated circuits.

In order to allow a deposition on a substrate comprising a dielectric surface a seed layer needs to be applied to the surface. Such seed lay may consist of cobalt, iridium, osmium, palladium, platinum, rhodium, and ruthenium or alloys comprising such metals. Preferred is the deposition on a cobalt seed. The seed layers are described in detail e.g. in US20140183738 A.

The seed layer may be deposited or grown by chemical vapor deposition (CVD). atomic layer deposition (ALD), physical vapor deposition (PVD). Electroplating, electro less plating or other suitable process that deposits conformal thin films. In an embodiment, the cobalt seed layer is deposited to form a high quality conformal layer th.at sufficiently and evenly covers all exposed surfaces within the openings and top Surfaces. The high quality seed layer may be formed, in one embodiment. by depositing the cobalt seed material at a slow deposition rate to evenly and consistently deposit the conformal seed layer. By forming the seed layer in a conformal manner, compatibility of a subsequently formed fill material with the underlying structure may be improved. Specifically, the seed layer can assist a deposition process by providing appropriate surface energetics for deposition thereon.

Preferably the substrate comprises submicrometer sized features and the cobalt deposition is performed to fill the submicrometer sized features. Most preferably the submicrometer-sized features have an (effective) aperture size of 10 nm or below and/or an aspect ratio of 4 or more. More preferably the features have an aperture size of 7 nanometers or below, most preferably of 5 nanometers or below.

The aperture size according to the present invention means the smallest diameter or free distance of a feature before plating, i.e. after seed deposition. The terms "aperture" and "opening" are used herein synonymously.

The electrodeposition current density should be chosen to promote the void-free, particularly the bottom-up filling behavior. A range of 0.1 to 40 mA/cm² is useful for this purpose. In a particular example, the current density can range from 1 to 10 mA/cm². In another particular example, the current density can range from 5 to 15 mA/cm².

The general requirements for a process of cobalt electrodeposition on semiconductor integrated circuit substrates is described in US 2011/0163449 A1.

Typically, substrates are electroplated by contacting the substrate with the plating baths of the present invention. The substrate typically functions as the cathode. The plating bath contains an anode, which may be soluble or insoluble. Optionally, cathode and anode may be separated by a membrane. Potential is typically applied to the cathode. Sufficient current density is applied and plating performed for a period of time sufficient to deposit a metal layer, such as a cobalt layer, having a desired thickness on the substrate. Suitable current densities include, but are not limited to, the range of 1 to 250 mA/cm². Typically, the current density is in the range of 1 to 60 mA/cm² when used to deposit cobalt in the manufacture of integrated circuits. The specific current density depends on the substrate to be plated, the leveling agent selected and the like. Such current density choice is within the abilities of those skilled in the art. The applied current may be a direct current (DC), a pulse current (PC), a pulse reverse current (PRC) or other suitable current. Typical temperatures used for the cobalt electroplating are from 10°C to 50°C, preferably 20°C to 40°C, most preferably from 20°C to 35°C.

In general, when the present invention is used to deposit metal on a substrate such as a wafer used in the manufacture of an integrated circuit, the plating baths are agitated during use. Any suitable agitation method may be used with the present invention and such methods are well-known in the art. Suitable agitation methods include, but are not limited to, inert gas or air sparging, work piece agitation, impingement and the like. Such methods are known to those skilled in the art. When the present invention is used to plate an integrated circuit substrate, such as a wafer, the wafer may be rotated such as from 1 to 300 RPM and the plating solution contacts the rotating wafer, such as by pumping or spraying. In the alternative, the wafer need not be rotated where the flow of the plating bath is sufficient to provide the desired metal deposit.

Cobalt is deposited in apertures according to the present invention without substantially forming voids within the metal deposit.

As used herein, void-free fill may either be ensured by an extraordinarily pronounced bottom-up cobalt growth while perfectly suppressing the sidewall cobalt growth, both leading to a flat growth front and thus providing substantially defect free trench/via fill (so-called bottom-up-fill) or may be ensured by a so-called V-shaped filling.

As used herein, the term "substantially void-free", means that at least 95% of the plated apertures are void-free. Preferably that at least 98% of the plated apertures are void-free, mostly preferably all plated apertures are void-free. As used herein, the term "substantially seam-free", means that at least 95% of the plated apertures are void-free. Preferably that at least 98% of the plated apertures are seam-free, mostly preferably all plated apertures are seam-free.

Plating equipment for plating semiconductor substrates are well known. Plating equipment comprises an electroplating tank which holds Co electrolyte and which is made of a suitable material such as plastic or other material inert to the electrolytic plating solution. The tank may be cylindrical, especially for wafer plating. A cathode is horizontally disposed at the upper part of tank and may be any type substrate such as a silicon wafer having openings such as trenches and vias. The wafer substrate is typically coated with a seed layer of Co or other metal or a metal containing layer to initiate plating thereon. An anode is also preferably circular for wafer plating and is horizontally disposed at the lower part of tank forming a space between the anode and cathode. The anode is typically a soluble anode.

These bath additives are useful in combination with membrane technology being developed by various tool manufacturers. In this system, the anode may be isolated from the organic bath additives by a membrane. The purpose of the separation of the anode and the organic bath additives is to minimize the oxidation of the organic bath additives.

The cathode substrate and anode are electrically connected by wiring and, respectively, to a rectifier (power supply). The cathode substrate for direct or pulse current has a net negative charge so that Co ions in the solution are reduced at the cathode substrate forming plated Co metal on the cathode surface. An oxidation reaction takes place at the anode. The cathode and anode may be horizontally or vertically disposed in the tank.

While the process of the present invention has been generally described with reference to semiconductor manufacture, it will be appreciated that the present invention may be useful in any electrolytic process where a substantially void-free cobalt deposit is desired. Such processes include printed wiring board manufacture. For example, the present plating baths may be useful for the plating of vias, pads or traces on a printed wiring board, as well as for bump plating on wafers. Other suitable processes include packaging and interconnect manufacture. Accordingly, suitable substrates include lead frames, interconnects, printed wiring boards, and the like.

All percent, ppm or comparable values refer to the weight with respect to the total weight of the respective composition except where otherwise indicated. All cited documents are incorporated herein by reference.

### Embodiments

1. A composition comprising
   (a) cobalt ions, and
   (b) an additive of formula I 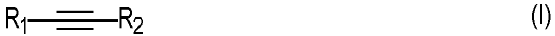 wherein
      - R¹: is selected from X-Y;
      - R²: is selected from R¹ and R³;
      - X: is selected from linear or branched C₁ to C₁₀ alkanediyl, linear or branched C₂ to C₁₀ alkenediyl, linear or branched C₂ to C₁₀ alkynediyl, and (C₂H₃R⁶-O)ₘ-H;
      - Y: is selected from OR³, NR³R⁴, N⁺R³R⁴R⁵ and NH-(C=O)-R³;
      - R³, R⁴, R⁵: are the same or different and are selected from (i) H, (ii) C₅ to C₂₀ aryl, (iii) C₁ to C₁₀ alkyl (iv) C₆ to C₂₀ arylalkyl, (v) C₆ to C₂₀ alkylaryl, which may be substituted by OH, SO₃H, COOH or a combination thereof, and (vi) (C₂H₃R⁶-O)ₙ-H, and wherein R³ and R⁴ may together form a ring system, which may be interrupted by O or NR⁷;
      - m, n: are integers independently selected from 1 to 30;
      - R⁶: is selected from H and C₁ to C₅ alkyl;

      - R⁷: is selected from R⁶ and 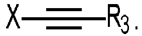
2. The composition according to embodiment 1, wherein X is selected from C₁ to C₆ alkanediyl.
3. The composition according to embodiment 2, wherein X is selected from methanediyl .
4. The composition according to embodiment 2, wherein X is selected from 1,1 or 1,2 ethanediyl.
5. The composition according to embodiment 2, wherein X is selected from propan-1,1-diyl, butane-1,1-diyl, pentane-1,1-diyl, hexane-1,1-diyl, propane-2-2-diyl, butane-2,2-diyl, pentane-2,2-diyl, and hexane-2,2-diyl. is elected from propane-1-2-diyl, butane-1,2-diyl, pentane-1,2-diyl, hexane-1,2-diyl, propane-1-3-diyl, butane-1,3-diyl, pentane-1,3-diyl, and hexane-1,3-diyl.
6. The composition according to anyone of the preceding embodiments, wherein R² is H.
7. The composition according to anyone of the preceding embodiments, wherein Y is OR³ and R³ is H.
8. The composition according to anyone of embodiments 1 to 6, wherein Y is OR³ and R³ is selected from polyoxyalkylene groups of formula (C₂H₃R⁶-O)ₙ-H.
9. The composition according to anyone of embodiments 1 to 6, wherein Y is NR³R⁴ and R³ and R⁴ are independently selected from H, methyl or ethyl.
10. The composition according to anyone of embodiments 1 to 6, wherein Y is NR³R⁴ and wherein R³ and R⁴ are H or one of R³ and R⁴ is H.
11. The composition according to anyone of embodiments 1 to 6, wherein Y is NR³R⁴ and at least one of R³ and R⁴, preferably both, are selected from polyoxyalkylene groups of formula (C₂H₃R⁶-O)ₙ-H.
12. The composition according to anyone of embodiments 1 to 6, wherein Y is N⁺R³R⁴R⁵ and R³, R⁴ and R⁵ are independently selected from H, methyl or ethyl.
13. The composition according to anyone of embodiments 1 to 6, wherein Y is N⁺R³R⁴R⁵ and at least one of R³ and R⁴, preferably two, most preferably all, are selected from polyoxyalkylene groups of formula (C₂H₃R⁶-O)ₙ-H.
14. The composition according to anyone of the preceding embodiments, which is essentially free from chloride ions.
15. The composition according to anyone of the preceding embodiments, which has a pH of 2 to 4.
16. Use of a compound of formula I 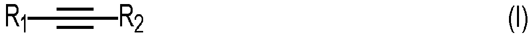 for depositing cobalt on semiconductor substrates comprising recessed features having an aperture size below 100 nm, preferably below 50 nm
   wherein
   - R¹: is selected from X-Y;
   - R²: is selected from R¹ and R³;
   - X: is selected from linear or branched C₁ to C₁₀ alkanediyl, linear or branched C₂ to C₁₀ alkenediyl, linear or branched C₂ to C₁₀ alkynediyl, and (C₂H₃R⁶-O)ₘ-H;
   - Y: is selected from OR³, NR³R⁴, N⁺R³R⁴R⁵ and NH-(C=O)-R³;
   - R³, R⁴, R⁵: are the same or different and are selected from (i) H, (ii) C₅ to C₂₀ aryl, (iii) C₁ to C₁₀ alkyl (iv) C₆ to C₂₀ arylalkyl, (v) C₆ to C₂₀ alkylaryl, which may be substituted by OH, SO₃H, COOH or a combination thereof, and (vi) (C₂H₃R⁶-O)ₙ-H, and wherein R³ and R⁴ may together form a ring system, which may be interrupted by O or NR⁷;
   - m, n: are integers independently selected from 1 to 30;
   - R⁶: is selected from H and C₁ to C₅ alkyl;

   - R⁷: is selected from R⁶ and 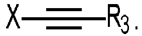
17. The use according to embodiment 16, wherein the recessed features have an aspect ratio of 4 or more.
18. The use according to anyone of embodiments 16 or 17, wherein the semiconductor substrate is a dielectric substrate to which a seed layer is placed on.
19. The use according to embodiment 18, wherein the seed layer consists of cobalt, iridium, osmium, palladium, platinum, rhodium, ruthenium, and alloys thereof.
20. A process for depositing cobalt on a semiconductor substrate comprising a recessed feature having an aperture size below 100 nm, preferably below 50 nm, the process comprising
   (a) bringing a composition according to anyone of embodiments 1 to 12 into contact with the semiconductor substrate,
   (b) applying a current for a time sufficient to fill the recessed feature with cobalt.
21. The process according to embodiment 20, wherein the recessed features have an aspect ratio of 4 or more.
22. The process according to anyone of embodiments 20 or 21, comprising a step (a1) comprising depositing a seed layer on a dielectric surface of the recessed feature before step (a).
23. The process according to embodiment 22, wherein the seed layer consists of cobalt, iridium, osmium, palladium, platinum, rhodium, ruthenium, and alloys thereof, preferably of cobalt.

The following examples shall further illustrate the present invention without restricting the scope of this invention.

### Examples

### Example 1 (comparative)

A 250 ml apparatus flushed with nitrogen was charged with 1,1-dimethyl-prop-3-ynilamine (7,9 g, 100 mmol) and water. The resulting mixture was stirred at ambient temperature and dimethylsulfate (12.6 g, 100 mmol) was added (0.2 ml/min). After the complete addition, the mixture was heated to 40 °C and was stirred for additional 5 hrs to obtain full conversion. Full conversion was determined by the test for the presence of electrophilic reagents (Preussman test). The mixture was cooled to ambient temperature and the title product was obtained as a colourless aqueous solution.

### Comparative Example 2

A cobalt electroplating bath containing 0.4 mol/l CoSO₄*7H₂O, 0.1 mol/l CoCl₂*6H₂O, 0.5 mol/l H₃BO₃, in DI water was prepared and adjusted afterwards to pH 3.5 with sulfuric acid.

Cobalt was electroplated onto the wafer substrate having a 12 nm thick CVD Co layer by contacting and rotate the substrate at 300 rpm at 35 degrees C applying a direct current of -5 mA/cm² for 150 s. The thus electroplated cobalt was investigated by FIB/SEM.

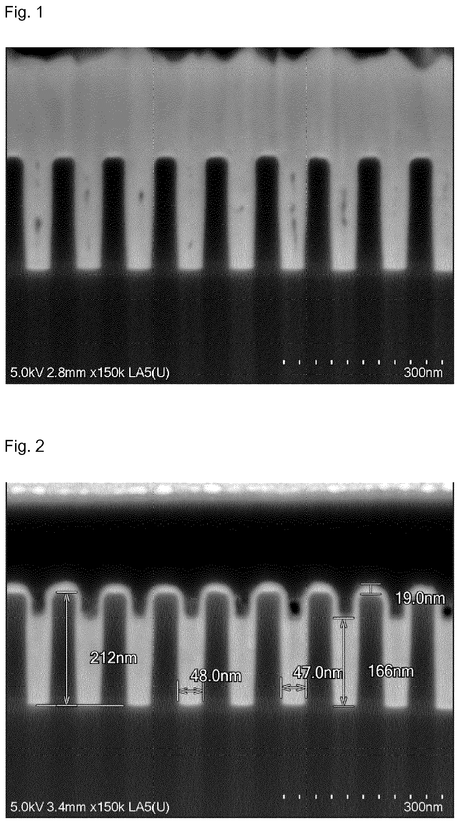

The result (see Fig. 1) shows a cobalt deposition which fails in the desired filling. This can be clearly seen by the void formation within the trenches.

### Example 3:

A cobalt electroplating bath containing 0.4 mol/l CoSO₄*7H₂O, 0.1 mol/l CoCl₂*6H₂O, 0.5 mol/l H₃BO₃, in DI water was prepared and adjusted afterwards to pH 3.5 with sulfuric acid. Additionally, 40 ml/l of a 1 % by weight solution of example 1 was added.

Cobalt was electroplated onto the wafer substrate having a 12 nm thick CVD Co layer by contacting and rotating the substrate with 300 rpm at 35 degrees C and applying a direct current of -5 mA/cm² for 150 s. The thus electroplated cobalt was investigated by FIB/SEM.

The result (see Fig. 2) shows a cobalt deposition which shows the desired filling behavior. This can be clearly seen by a void-free filling in the trenches.

### Example 4:

A cobalt electroplating bath containing 3 g/l Co ions (prepared by adding CoSO4x7H20 as the cobalt source), 33 g/l H₃BO₃, in DI water was prepared the pH was adjusted to 4. Additionally, 25 ml/l of a 0.18 % by weight solution of propargyl alcohol was added.

Cobalt was electroplated onto the wafer substrate having a 12 nm thick CVD Co layer by contacting and rotating the substrate with 100 rpm at 25 degrees C and applying a direct current of -5 mA/cm² and a total charge of 100 mC/cm². The thus electroplated cobalt was investigated by FIB/SEM.

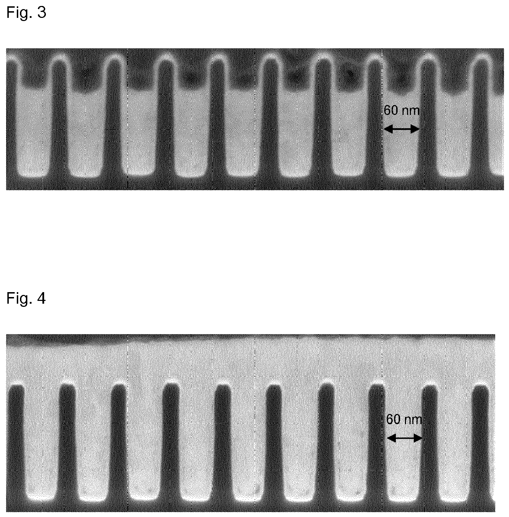

The result (see Fig. 3) shows a cobalt deposition which shows the desired filling behavior. This can be clearly seen by a void-free filling in the trenches.

### Example 5:

A cobalt electroplating bath containing 3 g/l Co ions (prepared by adding CoSO4x7H20 as the cobalt source), 33 g/l H₃BO₃, in DI water was prepared the pH was adjusted to 3. Additionally, 75 ml/l of a 0.18 % by weight solution of propargyl alcohol ethoxylate was added.

Cobalt was electroplated onto the wafer substrate having a 12 nm thick CVD Co layer by contacting and rotating the substrate with 100 rpm at 25 degrees C applying a direct current of - 2 mA/cm² and a total charge of 100 mC/cm². The thus electroplated cobalt was investigated by FIB/SEM.

The result (see Fig. 4) shows a cobalt deposition which shows the desired filling behavior. This can be clearly seen by a void-free filling in the trenches.

## Claims

1. Use of a compound of formula I 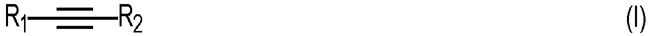 for depositing cobalt on semiconductor substrates comprising recessed features having an aperture size below 100 nm, preferably below 50 nm
wherein
R¹ is selected from X-Y;
R² is selected from R¹ and R³;
X is selected from linear or branched C₁ to C₁₀ alkanediyl, linear or branched C₂ to C₁₀ alkenediyl, linear or branched C₂ to C₁₀ alkynediyl, and -(C₂H₃R⁶-O)ₘ-;
Y is selected from OR³;
R³ is selected from (i) H, (ii) C₅ to C₂₀ aryl, (iii) C₁ to C₁₀ alkyl (iv) C₆ to C₂₀ arylalkyl, (v) C₆ to C₂₀ alkylaryl, which may be substituted by OH, SO₃H, COOH or a combination thereof, and (vi) (C₂H₃R⁶-O)ₙ-H, ;
m, n are integers independently selected from 1 to 30;
R⁶ is selected from H and C₁ to C₅ alkyl.

2. The use according to claim 1, wherein X is selected from C₁ to C₆ alkanediyl.

3. The use according to claim 2, wherein X is selected from methanediyl or 1,1- or 1,2-ethanediyl.

4. The use according to claim 2, wherein X is selected from propane-1,1-diyl, butane-1,1-diyl, pentane-1,1-diyl, hexane-1,1-diyl, propane-2-2-diyl, butane-2,2-diyl, pentane-2,2-diyl, and hexane-2,2-diyl. is elected from propane-1-2-diyl, butane-1,2-diyl, pentane-1,2-diyl, hexane-1,2-diyl, propane-1-3-diyl, butane-1,3-diyl, pentane-1,3-diyl, and hexane-1,3-diyl.

5. The use according to anyone of the preceding claims, wherein R² is H.

6. The use according to anyone of the preceding claims, wherein R³ is H.

7. The use according to anyone of claims 1 to 5, wherein R³ is selected from polyoxyalkylene groups of formula (C₂H₃R⁶-O)ₙ-H.

8. The use according to anyone of the preceding claims, wherein the compound is used in a composition which is essentially free from chloride ions.

9. The use according to anyone of the preceding claims, wherein the compound is used in a composition which has a pH of 2 to 4.

10. The use according to anyone of the preceding claims, wherein the recessed features have an aspect ratio of 4 or more.

11. The use according to anyone of the preceding claims, wherein the semiconductor substrate is a dielectric substrate to which a seed layer is placed on.

12. The use according to claim 11, wherein the seed layer consists of cobalt, iridium, osmium, palladium, platinum, rhodium, ruthenium, and alloys thereof.

13. A process for depositing cobalt on a semiconductor substrate comprising a recessed feature having an aperture size below 100 nm, preferably below 50 nm, the process comprising
(a) bringing a composition into contact with the semiconductor substrate, the composition comprising a compound of formula I 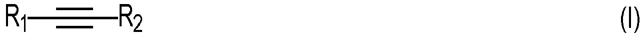
(b) applying an electric current for a time sufficient to fill the recessed feature with cobalt,
wherein
R¹ is selected from X-Y;
R² is selected from R¹ and R³;
X is selected from linear or branched C₁ to C₁₀ alkanediyl, linear or branched C₂ to C₁₀ alkenediyl, linear or branched C₂ to C₁₀ alkynediyl, and -(C₂H₃R⁶-O)ₘ-;
Y is selected from OR³;
R³ is selected from (i) H, (ii) C₅ to C₂₀ aryl, (iii) C₁ to C₁₀ alkyl (iv) C₆ to C₂₀ arylalkyl, (v) C₆ to C₂₀ alkylaryl, which may be substituted by OH, SO₃H, COOH or a combination thereof, and (vi) (C₂H₃R⁶-O)ₙ-H, ;
m, n are integers independently selected from 1 to 30;
R⁶ is selected from H and C₁ to C₅ alkyl.

14. The process according to claim 13, wherein the recessed features have an aspect ratio of 4 or more.

15. The process according to anyone of claims 13 or 14, comprising a step (a1) comprising depositing a seed layer on a dielectric surface of the recessed feature before step (a).
